(19) Europäisches Patentamt

European Patent Office

Office européen des brevets

(11) EP 1 544 760 A2

(12) EUROPEAN PATENT APPLICATION

(43) Date of publication:
22.06.2005 Bulletin 2005/25

(51) Int Cl.7: G06F 17/50

(21) Application number: 04257837.7

(22) Date of filing: 16.12.2004

(84) Designated Contracting States:
AT BE BG CH CY CZ DE DK EE ES FI FR GB GR
HU IE IS IT LI LT LU MC NL PL PT RO SE SI SK TR
Designated Extension States:
AL BA HR LV MK YU

(30) Priority: 18.12.2003 JP 2003421369

(71) Applicant: NISSAN MOTOR COMPANY, LIMITED
Yokohama-shi, Kanagawa 221-0023 (JP)

(72) Inventors:
• Katayama, Takeshi
  Kanagawa-ken 243-0032 (JP)
• Mashio, Kousuke
  30419 Hannover (DE)
• Watanabe, Shinji
  Kanagawa-ken 229-0006 (JP)

(74) Representative: Godwin, Edgar James
Marks & Clerk
57-60 Lincoln's Inn Fields
London WC2A 3LS (GB)

(54) **Three dimensional road-vehicle modeling system**

(57)    A three dimensional road-vehicle modeling system includes a personal computer (1) to store data on three dimensional road and virtual vehicle model, a real time simulator (2) to run a simulation based on the data and model, and actual test parts (5 to 16). A three dimensional course line (LC3) of a vehicle (50) is set on the three dimensional road. The simulator (2) converts the three dimensional course line (LC3) on the three dimensional road into a two dimensional course line (LC2) on a two dimensional plane determined based on inclination of the three dimensional road and then converts the two dimensional course line (LC2) into a straight course line (LC1) corresponding to a three dimensional road model on the two dimensional plane based on hypothetical external force acting on the vehicle (50). These three dimensional road and virtual vehicle models are used to evaluate compatibility between the actual parts (5 to 16) and the test vehicle (50).

FIG. 1A

EP 1 544 760 A2

**Description**

The present invention relates to a three dimensional road-vehicle modeling system that can construct a three dimensional road environment model representing a banked road and a slope so as to simulate three dimensional road behavior of a test vehicle.

Recently, rapid progress in electronics technology and needs for social safety and better environment affect vehicle control systems to have high functions and complicate construction. In addition, such control systems need to be developed in a short time so as to timely afford products with the control systems. Hardware In the Loop Simulation (HILS) has been coming under the spotlight as an evaluation and/or verification tool in solving the above challenges.

The HILS can evaluate an actual control system to be tested in a virtual world by combining the actual control system and a model of vehicle elements except the control system and simulating its behavior. For example, it is important that the model can represent an actual behavior of a vehicle faithfully under the condition of ensuring high speed processing when developing an anti-skid brake system, such as a Vehicle Dynamics Control (VDC) system.

Road-vehicle modeling systems of this kind are disclosed in Japanese patent laying-open publications No. 2000-329657 and No. 2001-349808. The former modeling system builds a vehicle model allowing for non-linear part of tires, while the latter modeling system builds a vehicle model obtained by using an identification and correction method and actual vehicle data. These vehicle models are simulated to run on a two dimensional model road.

The above known conventional road-vehicle modeling systems, however, encounter a problem that the system can not represent behavior of a test vehicle running on a three dimensional road, such as a banked road and/or a slope. When a three dimensional road model is adopted in order to overcome the above problem, the HILS can hardly function on a normal computer, such as a personal computer, because of processing a large data on the road model.

It is, therefore, an object of the present invention to provide a three dimensional road-vehicle modeling system which overcomes the foregoing drawbacks and can reduce processing load and duly represent road behavior of a vehicle running on a three dimensional road.

It is another object of the present invention to provide a three dimensional road-vehicle modeling method which overcomes the foregoing drawbacks and can reduce processing load and duly represent road behavior of a vehicle running on a three dimensional road.

According to a first aspect of the present invention there is provided a three dimensional road-vehicle modeling system comprising: an input device to input three dimensional road data on a three dimensional road; a road data storing medium to store the three dimensional road data inputted from the input device; a three dimensional course line setting device to set a three dimensional course line of a vehicle running on the three dimensional road; a first converter to convert the three dimensional course line on the three dimensional road obtained from the road data storing medium into a two dimensional course line on a two dimensional plane determined based on inclination of the three dimensional road; and a second converter to convert the two dimensional course line into a straight course line corresponding to a three dimensional road model on the two dimensional plane based on hypothetical external force acting on the vehicle.

According to a second aspect of the present invention there is provided a three dimensional road-vehicle modeling method comprising: inputting three dimensional road data on a three dimensional road; storing the three dimensional road data on the three dimensional road; setting a three dimensional course line of a vehicle running on the three dimensional road; converting the three dimensional course line on the three dimensional road into a two dimensional course line on a two dimensional plane determined based on inclination of the three dimensional road; and further converting the two dimensional course line into a straight course line corresponding to a three dimensional road model on the two dimensional plane based on hypothetical external force acting on the vehicle.

The objects, features and advantages of the present invention will become apparent as the description proceeds when taken in conjunction with the accompanying drawings, in which:

FIG. 1A is a three dimensional road-vehicle modeling system of an embodiment according to the present invention;
Fig. 1B is a display image on a screen of a personal computer used in the three dimensional road-vehicle modeling system shown in FIG. 1;
FIG. 2 is a block diagram showing a procedure of a simulation executed by the modeling system;
FIG. 3 is a schematic diagram showing a Vehicle Dynamics Control (VDC) system installed on a vehicle;
FIG. 4 is a schematic diagram showing a brake fluid control system used in the VDC system shown in FIG. 3;
FIG. 5 is a comparison table of running states between the vehicles with the VDC system and without it when the vehicles corner on a slippery surface road;
FIG. 6 is a comparison table of running states between the vehicles with the VDC system and without it when the vehicles corner on a slippery surface road;
FIG. 7A is a schematic diagram showing a three dimensional set-up course line of a three dimensional course of a banked road;

FIG. 7B is a schematic diagram showing a two dimensional set-up course line converted from the three dimensional set-up course line shown in FIG. 7A;

FIG. 7C is a schematic diagram showing a one dimensional set-up course line converted from the two dimensional set-up course line shown in FIG. 7B;

FIG. 8 is a schematic diagram showing relationships of centrifugal force and its y and z components acting on the vehicle running on the banked road;

FIG. 9A is a schematic diagram showing relationships of gravity and its y and z components due to gravity and slope angle that acts on the vehicle running on the banked road;

FIG. 9B is a schematic diagram showing relationships of gravity and its x and z components due to gravity and slope angle that acts on the vehicle running on the banked road;

FIG. 10 is a flow chart of a three dimensional road modeling process executed by a real time simulator used in the three dimensional road- vehicle modeling system shown in FIG. 1;

FIG. 11 is an evaluation table among the three road models;

FIG. 12 is a comparison table between actual vehicle data and simulation data of four test vehicles;

FIG. 13A is a comparison table of yaw rate obtained by using an actual vehicle and the simulation with respect to vehicle speed when the vehicle runs on road with the bank of the highest inclination; and

FIG. 13B is a comparison table of lateral acceleration obtained by using the actual vehicle and the simulation with respect to the vehicle speed when the vehicle runs on road with the bank of the highest inclination.

Throughout the following detailed description, similar reference characters and numbers refer to similar elements in all figures of the drawings, and their descriptions are omitted for eliminating duplication.

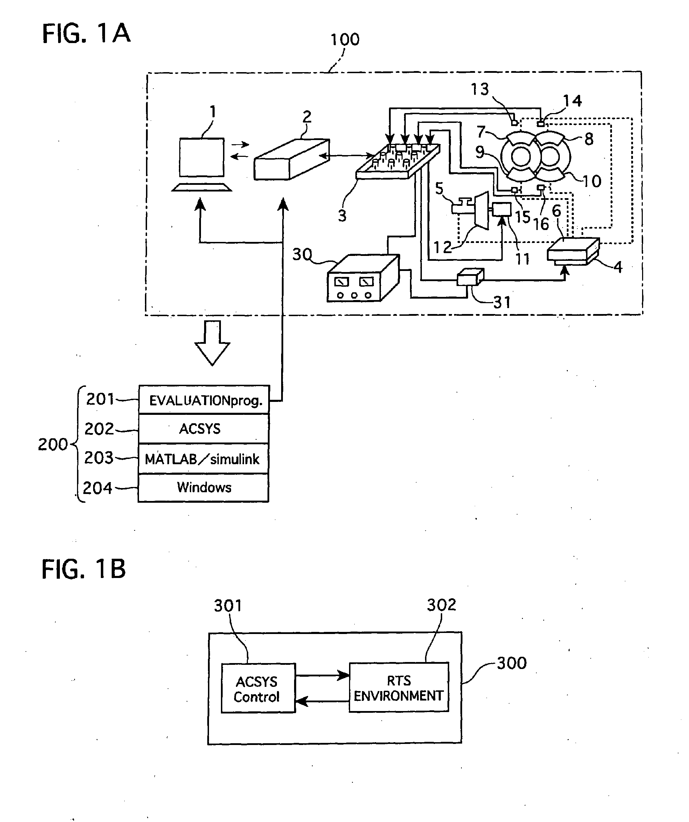

Referring to FIG. 1 of the drawing, there is shown three dimensional road-vehicle modeling system of a first preferred embodiment according to the present invention.

The modeling system includes a simulating system to simulate behavior of a vehicle using a road-vehicle model and an actual control system to be installed on the vehicle and evaluated. In this modeling system of the embodiment, the modeling system is used for developing a vehicle with the actual control system, for example, a vehicle dynamic control (VDC) system. The VDC system automatically controls individual wheel brake pressure and engine torque based on steering angle, G-force, wheel speed, brake pressure and other factors to reduce understeer or oversteer in slippery situations.

The simulating system includes a personal computer 1 installed with software 200 and data on a virtual road and vehicle models and road information, a real time simulator 2 connected to the road and personal computer 1 to simulate the behavior of a test vehicle using the road and vehicle models, an input/output box 3 connected to the real time simulator 2 and the VDC system, a power supply 30, and a relay box 31.

The personal computer 1 and the simulator 2 contains the software 200, such as an evaluation program 201, automatic continuous simulation system (ACSYS) 202, MATLAB/simulink (registered trademark) 203, and Windows (registered trademark) 204 as OS.

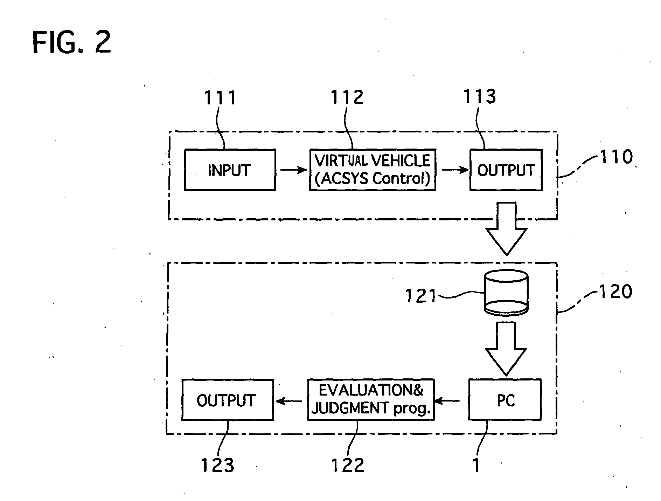

As shown in FIGS. 1 and 2, the personal computer 1 has an input part 11 and a course line setting part 114 to set a three dimensional set-up course line of a three dimensional road, and stores virtual vehicle models 113 and three dimensional road models 113 of the tree dimensional road in a hard disc 121. The computer 1 act as an input device of the present invention. The hard disc 121 corresponds to a road data storing medium of the present invention. The input part 111 corresponds to an input device of the present invention. The three dimensional set-up course line LC3 is set by a course line setting part 114 of the personal computer 1, or may be set by the real time simulator 2. The course line setting part 114 acts as a three dimensional course line setting device of the present invention. FIG. 1B shows an image on a display screen 301 of the computer 1, showing a relationship between the control state of the ACSYS 301 and contents of a real time simulation (RTS) environment 300.

The evaluation program 122 is used for evaluation of compatibility between a developing vehicle and an actual test VDC system, by comparing master data to test data. The master data is one on the VDC system and the vehicle that are evaluated in advance to be in compatible with each other, while the test data is one on the actual test VDC system and the developing vehicle to be installed with the test VDC system. This results obtained from the evaluation program 122 is displayed on an output part 123, such as a display of the computer 1.

The virtual vehicle model is constructed for representing vehicle behavior in real time by using characteristic parameters of parts or units which are intended for design study. This vehicle model is newly set to be one representing the developing vehicle by adding part element models for the test VDC system to the developing vehicle model and inputting characteristic values of the test VDC system and the developing vehicle model. Accordingly, this vehicle model can be used for analyzing and evaluating vehicle stability, steerabilty, and/or ride performance in addition to the VDC sysytem. The parts element models, for example, include those of an engine, a drive train, a brake, and a tire, while the vehicle model has device element models such as a suspension, a steering device, and a chassis. The parts element models can be selected by operating switches so that they are shifted to fit into the developing the virtual vehicle model that is necessary for running real-time simulation. To run the simulation , the system needs an existing vehicle model for obtaining master data and a developing vehicle model for obtaining test data on the developing system to be evaluated.

The MATLAB/simulink is a multi-purpose modeling program, which is used for vehicle modeling and running environment setting. The environment setting includes three dimensional road environment setting to obtain a three dimensional road model, which is a one dimensional course line, a straight line where the vehicle runs, converted from a three dimensional course line of the vehicle running on the three dimensional road. The three dimensional road model will be described in detail later.

The real time simulator 2 includes, as shown in FIG. 2, a first conversion part 211 to obtain a two dimensional set-up course line from the three dimensional set-up course line, and a second conversion part to obtain a one dimensional set-up course line from the two dimensional set-up course line. The first and second conversion parts 211 and 212 correspond to first and second converters of the present invention, respectively. The simulator 2 downloads the virtual vehicle model of the developing vehicle, compiled in a form where a PPC (registered trademark) can run, from the personal computer 1, and runs a VDC simulation by every control period of one millisecond in real time. For example, when the virtual vehicle model changes lane or corners under control of the VDC system, data on steering angle of a steering wheel is inputted, and then the steering angle data is converted into actual steering angle data of wheels, then steering the wheels.

The input/output box 3 provides the VDC/TCS/ABS control unit 4 through a digital/analog (D/A) board by every control period of 10 milliseconds with analog sensor signals of wheel speeds of a front left, front right, rear left, and rear right wheels, yaw rate, acceleration in a lateral direction of the vehicle, and steering angle that are necessary for operating the VDC/TCS/ABS control unit 4. These sensor signals are obtained by computation in the real-time simulator 2 using the virtual vehicle model. The sensor signals may be inputted to the control unit 4 as Controller Area Network (CAN) signals through a CAN board.

In the modeling system of the embodiment shown in FIG. 1, it employs an actual brake fluid control system including actual units of a master cylinder 5, a VDC/TCS/ABS actuator 6, and first to fourth brake wheel cylinders 7 to 10. First to fourth wheel brake pressure sensors 13 to 16 are disposed in brake passages connecting between the first to fourth brake wheel cylinders 7 to 10 and the master cylinder 5 respectively, and output their detected brake pressure signals directly to the input/output box 3.

There is also provided an alarm lamp so as to give the alarm when the modeling system malfunctions.

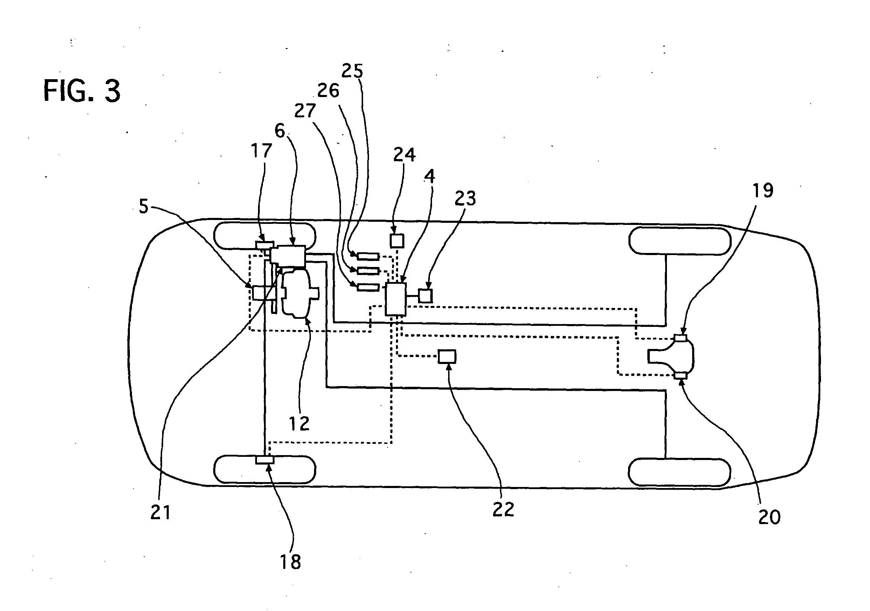

FIG. 3 schematically shows a vehicle with a VDC system including a brake fluid control system similar to that of the embodiment shown in FIG. 1. The VDC system on the vehicle is equipped with a VDC/TCS/ABS control unit 4, a master cylinder 5, a VDC/TCS/ABS actuator 6, a brake power booster 12, a yaw rate sensor 22 to output a yaw rate signal, a steering sensor to output a steering angle signal, first to fourth wheel speed sensors to output wheel speed signals, and a pressure sensor to output a pressure signal.

The VDC system automatically controls individual wheel brake pressure and engine torque based on steering angle, G-force, wheel speed, brake pressure and other factors to improve stability by compatibility with braking, starting, and cornering performances in adverse driving conditions, such as slippery situations.

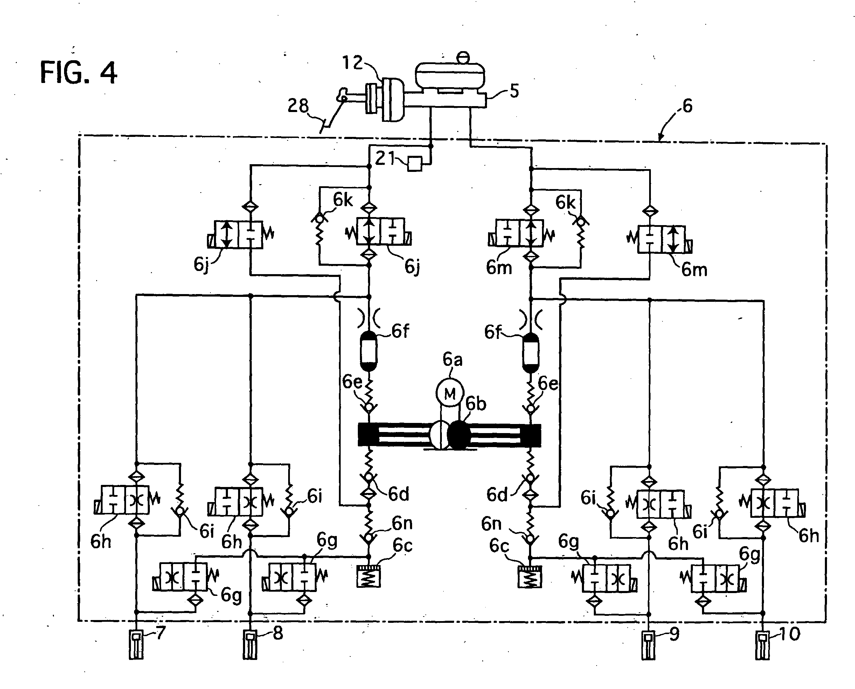

FIG. 4 schematically shows a brake fluid control system. The control system has the master cylinder 5 operated by a brake pedal 28, the VDC/TCS/ABS actuator 6, the brake power booster 12, and the first to fourth brake wheel cylinders 7 to 10.

The VDC/TCS/ABS actuator 6 is arranged between the master cylinder 5 and the first to fourth brake wheel cylinders 7 to 10, and equipped with an electric motor 6a, a fluid pump driven by the motor 6a to output pressurized brake fluid, two accumulators 6c connected with suction ports of the pump 6b, two inlet check valves 6d to allow only an inlet direction flow of the brake fluid, two outlet check valves 6e connected with discharge ports of the pump 6b to allow only an outlet direction of the fluid, two dumpers 6f to suppress vibration of the fluid, four outlet solenoid valves 6g, four inlet solenoid valves 6h, four return check valves 6i arranged in parallel with the inlet solenoid valves 6h, two front VDC shift valves 6j, two check valves 6k arranged in parallel with the front VDC shift valves 6j, two rear VDC shift valves 6m, and two check valves 6n in parallel with the rear VDC shift valves 6m.

In the VDC/TCS/ABS actuator 6, the VDC/TCS/ABS control unit 4 shown in FIG. 3 controls the solenoid valves 6g, 6h, 6j, and 6m so as to output controlled brake pressure to the brake wheel cylinders 7 to 10. The solenoid valves 6g, 6h, 6j, and 6m are controlled to shift brake pressure control modes: a normal brake mode where the VDC system is not operated, a pressure maintaining mode in the VDC operation, a pressure reducing mode in the VDC operation, and a pressure increasing mode in the VDC operation.

The VDC/TCS/ABS control unit 4 receives a steering angle signal from the steering angle sensor 18, a brake pressure signal from the brake pressure sensor 9, a yaw signal from the yaw rate sensor 22, wheel speed signals from the wheel speed sensors 13 to 16, and others. It judges a vehicle running state, for example, the understeer or oversteer amount of the vehicle based on the computation using a vehicle dynamics equation. When the amount exceeds an allowable value, the VDC/TCS/ABS control unit 4 controls the brake wheel pressures to ensure the stability of the vehicle, with controlling the engine if required.

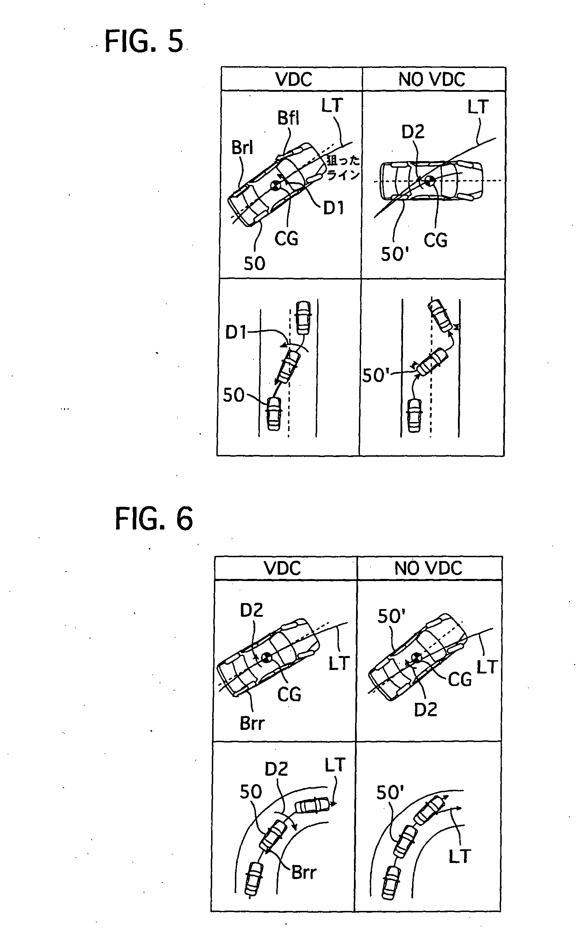

FIGS. 5 and 6 shows operation and advantages of the VDC system. FIG. 5 shows a comparison table of running states between vehicles with the VDC system and without it when the vehicles change a lane with a slippery road surface. The left part of this table shows the running state of the vehicle 50 with the VDC system, while the right part of the table shows the running state of the vehicle 50' without the VDC system. When the VDC system judges an oversteer state of the vehicle 50 due to the slippery road, the system controls the VDC actuator 6 to apply brake forces Bfl and Brl to the left front and rear wheel and produce stability torque in the counterclockwise direction D2 in FIG. 5, thus reducing its oversteer to keep the vehicle 50 running along its target course Lt. On the other hand, the vehicle 50' without the VDC system is oversteered and turns in the clockwise direction D2 to deviate inward from the target course LT.

FIG. 6 shows a comparison table of running states between the vehicles with the VDC system and without it when the vehicles corner on a slippery surface road. When the VDC system judges an understeer state of the vehicle 50 due to the slippery road, the system controls the VDC actuator to apply brake force Brr to the rear right wheel and produce stability torque in the clockwise direction D2 in FIG. 6, thus reducing its understeer to keep the vehicle 50 running along its target course Lt. On the other hand, the vehicle 50' without the VDC system is understeered and turns in the clockwise direction D2 to deviate outward from the target course LT.

As described above, the VDC system controls the VDC actuator 6 so as to mate a lateral slip amount obtained from information on the yaw rate, the wheel speeds, and others obtained from the sensors with a target lateral slip amount determined based on steering and brake operations by a driver when the vehicle changes lane or corners on a slippery surface road.

Next, the operation of the modeling system will be described with the accompanying drawings.

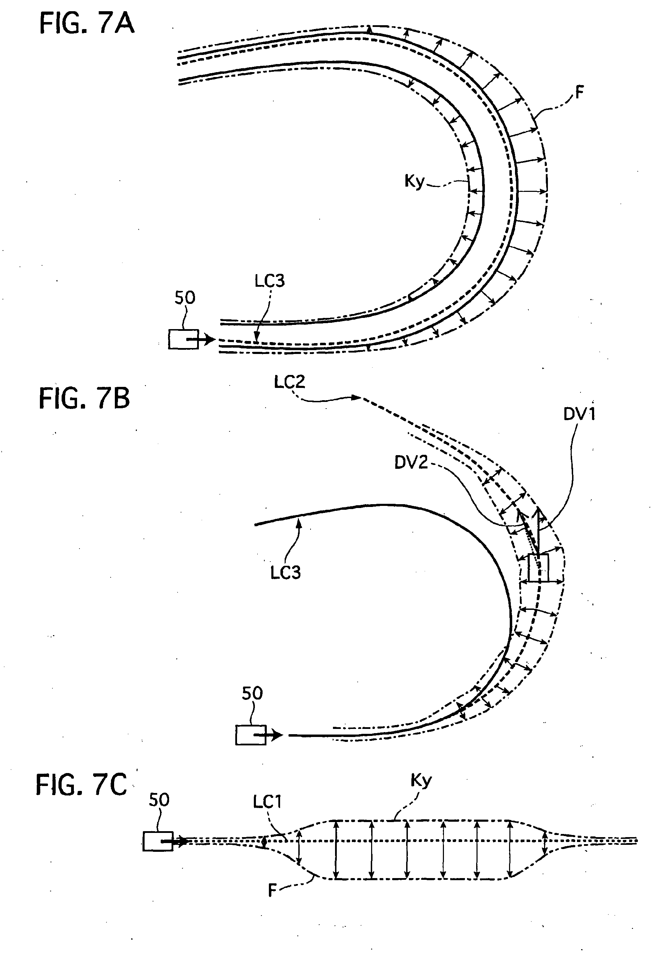

FIG. 7A to 7C schematically show a procedure of setting the three dimensional road environment model of a road with a banked road surface. In the simulation, the test vehicle 50 is set to run at speeds increased by 5 km/h on a three dimensional set-up course line LC3 in a banked course CB shown in FIG. 7A. Accordingly, the road-vehicle modeling system proceeds data on only the set-up course line LC3, and decides a present position of the vehicle 50 on the course CB based on its mileage traveled, then computing forces F and Ky that act on the vehicle 50 due to a road slope, vehicle speed, and others.

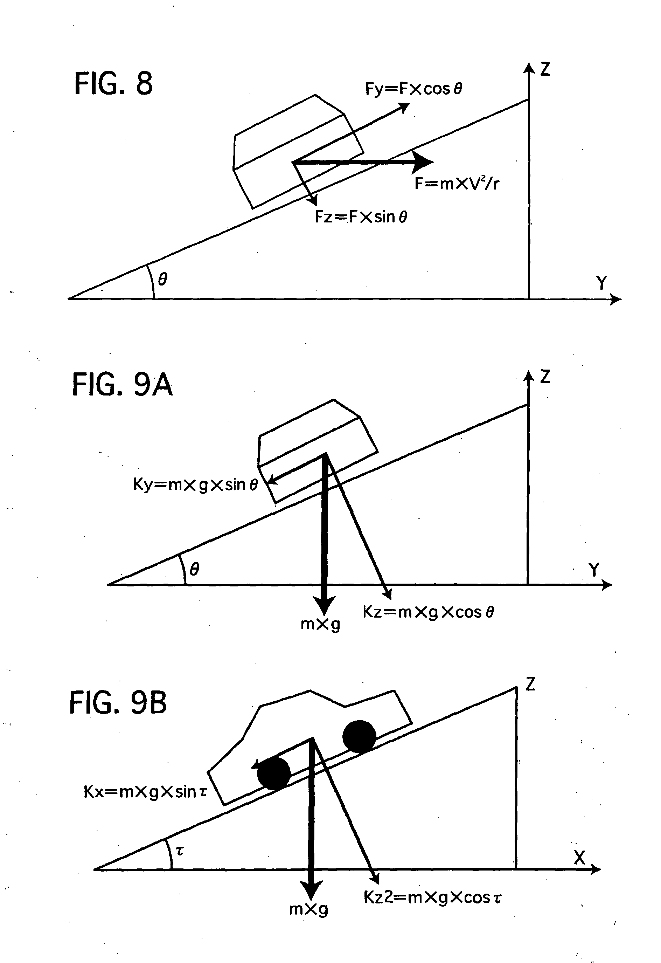

The three dimensional set-up course line LC3 is, as shown in FIG. 7B, converted by a first conversion part 211 of the real time simulator 2 into a two dimensional set-up course line LC2 of the vehicle 50 on a two dimensional plane according to bank angles θ, shown in FIG. 9A, of the course CB. The three dimensional set-up course line LC3 from the right overhead view is, namely, converted into an actual course line, referred to as the two dimensional set-up course line LC2, of the vehicle 50 on the plain surface.

Then, the two dimensional set-up course line LC2 is, as shown in FIG. 7C, converted by a second conversion part 212 of the real time simulator 2 into a strait line, a one dimensional set-up course LC1, referred to as a three dimensional road model. This conversion is made by virtually adding external forces, consisting of centrifugal force and gravity, acting on the mass center CG of the vehicle 50 and applying steering force at the steering angle Θ so that the vehicle can run straight on the one dimensional set-up course lane LC1, not so as to be deviated from it due to the external forces.

As shown in FIG. 8, the y- and z- components Fy and Fz of the centrifugal force F acting on the vehicle 50 are expressed as the following equations:

$$Fy = (m \times V^2/r) \times \cos \theta \qquad (1a)$$

$$Fz = (m \times V^2/r) \times \sin 0 \qquad (1b).$$

As shown in FIGS. 9A ands 9B, the x, y, and z components Kx, Ky, and Kz of road slope force, due to the gravity, acting on the vehicle 50, are computed as the following equations:

$$Kx = m \times g \times \sin \{atan(ykoubai)\} = m \times g \times \sin \theta \qquad (2a)$$

$$Ky = m \times g \times \sin \{atan(xkoubai)\} = m \times g \times \sin \tau \qquad (2b)$$

$$Kz = m \times g \times \cos\{atan(xkoubai)\} \times \cos\{atan(ykoubai)\} = m \times g \times \cos\tau \times \cos\theta \qquad (2c),$$

where m = vehicle mass, r = a radius of cornering, $\theta$ = a bank angle, Fy = a lateral component of the centrifugal force acting on the vehicle when running on a banked road, Fz = a vertical component of the centrifugal force acting on the vehicle when running on the banked road, Kx = a longitudinal component of the road slope force acting on the vehicle when running on the banked road, Ky = a lateral component of the road slope force acting on the vehicle when running on the banked road, Kz = a vertical component of the road slope force acting on the vehicle when running on the banked road, xkoubai = a slope angle in the longitudinal direction of the banked road, and ykoubai = a slope angle in the lateral direction of the banked road. These forces are feedback-inputted to the virtual vehicle model to compute a dynamics equation.

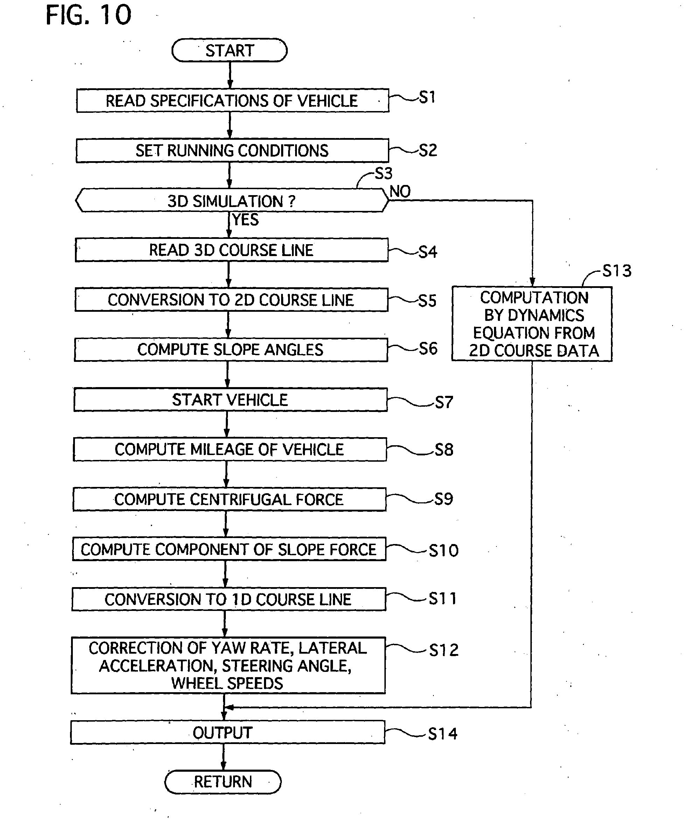

FIG. 10 shows a flowchart of a three dimensional road modeling process executed in the real time simulator 2.

At step S1, specifications and characteristic values of a test vehicle to be evaluated are read from the personal computer 1, and the flow goes to step S2.

At the step S2, running conditions of the vehicle are set, and then the flow goes to step S3. The running conditions are, for example, set that the vehicle runs at speeds increased by 5 Km/h on the set-up course line LC3 shown in FIG. 7A set in the three dimensional course of the road with bank.

At the step S3, the real time simulator 2 judges whether or not the running conditions set at the step S2 uses the three dimensional simulation. If YES, the flow goes to step S4, while, if NO, the flow goes to step S13.

At the step S4, data on the three dimensional set-up course line LC3 in the course is read from the personal computer 1, and then the flow goes to step S5.

At the step S5, the data on the three dimensional set-up course line LC3 is converted into data on a two dimensional set-up course line LC2 shown in FIG. 7B based on bank angle of the course, and then the flow goes to step S6.

At the step S6, a lateral slope angle "ykoubai" and a longitudinal slope angle "xkoubai" are computed based on the data on the three dimensional road of the course, and the flow goes to step S7. The lateral direction corresponds to perpendicular to a direction of the course, while the longitudinal direction corresponds to the direction of the course.

At the step S7, the vehicle starts to run on the two dimensional set-up course line LC2 obtained at the step S5, and then the flow goes to step S8.

At the step S8, mileage that the vehicle traveled is obtained by multiplying vehicle speed by its running time, and then the flow goes to step S9.

At the step S9, components of the centrifugal force acting on the vehicle are computed at every present position of the two dimensional set-up course line LC2 by using the above equations (1a) and (1b), and then the flow goes to step S10.

At the step S10, components of the road slope force acting on the vehicle are computed at every present position of the two dimensional set-up course line LC2 by using the above equations (2a) to (2b), and then the flow goes to step S11.

At the step S11, the data on the two dimensional set-up course line LC2 is converted into data on a one dimensional set-up course line LC1, the three dimensional road model, shown in FIG. 7C based on the components of the centrifugal force and the road slope force and the steering angle $\Theta$. The steering angle $\Theta$ is set so as to keep the vehicle running straight on the one dimensional set-up course lane LC1, not deviated from it due to the external forces. This data on the three dimensional road model is feedback-inputted to the three dimensional road-vehicle model, and a dynamics equation is computed based on the three dimensional road model and the virtual vehicle model, and then the flow goes to step S12.

At the step S12, yaw rate, lateral acceleration, a steering angle, wheel speed, and others of the vehicle are computed by using the dynamics equation, and the yaw rate, the lateral acceleration, the steering angle $\Theta$, and the wheel speeds are compensated in a manner described later, and then the flow goes to step S14.

At the step S13, a yaw rate, a lateral acceleration, steering angle $\Theta$, and wheel speeds are computed based on the data on the two dimensional set-up course line LC2 without correction by using the dynamics equation so as to be inputted to the VDC/TCS/ABS control unit 4, and then the flow goes to the step S 14.

At the step S14, the real time simulator 2 outputs the corrected yaw rate, the corrected lateral acceleration, the corrected steering angle, and the corrected wheel speeds, obtained at the step S13, to the VDC/TCS/ABS control unit 4 through the input/output box 3 and the relay box 31 when the three dimensional road-vehicle model is simulated. When the two dimensional road-vehicle model is simulated, the real time simulator 2 outputs the yaw rate, the lateral acceleration, the steering angle, and the wheel speeds. Obtained at the step S14, to the VDC/TCS/ABS control unit 4 through the input/output box 3 and the relay box 31.

The corrections of the yaw rate and the lateral acceleration are performed as follows. The yaw rate and the lateral acceleration of the vehicle are proportional to $\cos\theta$ when the vehicle corners on a banked road. The vehicle can corner on the banked road with a steering angle smaller than on a flat surface road. For example, the road with a bank angle of 90 degree enables the vehicle to corner with the steering angle of substantially zero.

Increase of bank angle decreases the yaw rate of the vehicle, which causes the two dimensional set-up course line LC2 to be a curve slower than the three dimensional set-up course line LC3 viewed from the right above, as shown in FIG. 7B. This means that the cornering radius of the vehicle becomes larger, which satisfies the equation: (cornering radius) = (vehicle speed) / (yaw rate). Therefore, the state quantity of the vehicle in the lateral direction, such as yaw rate, lateral acceleration, needs the following correction when the two dimensional set-up course line LC2 is converted into the one dimensional set-up course line LC1. The yaw rate of the vehicle on the banked road is calculated by multiplying the vehicle velocity V by a variation $\Delta\psi$ of the yaw rate with respect to a unit mileage. The variation $\Delta\psi$ is mapped along the course based on the date on the banked road.

$$\omega i' = \omega i \times \cos\theta \ (\omega i = \Delta\psi \times V)$$

$$Gy' = Gy \times \cos\theta,$$

Where $\omega i$ = yaw rate due to bank running, $\omega i'$ = corrected yaw rate, Gy = lateral acceleration, and Gy' = corrected lateral acceleration.

The corrections of the steering angle is performed as follows.

The wheels running on the banked road needs to be steered larger than the steering angle $\Theta$ obtained at the step S12 in order to run along the one dimensional set-up course line LC1. The steering angle $\Theta$ obtained at the step S12 brings the running direction of the vehicle 50 to be parallel with the line LC3, causing it to be on the tangent line DV1 as shown in FIG. 7B to the cornering course. Therefore, the steering angle $\Theta$ needs correction in order to run the vehicle straight on the line LC1 to head the vehicle 50 in a direction DV2 shown in FIG. 7B by adding a certain steering angle $\delta$ according to the corner so that the corrected angle is inputted to the VDC control unit 4.

The certain steering angle $\delta$ is obtained from the following equations.

$$\delta = \alpha \times L/r \qquad \text{(only geometrical correction)}$$

$$\delta = \alpha \times L \times (1 + A \times V^2)/r \qquad \text{(correction allowing for dynamic characteristic),}$$

where A = stability factor (an index showing steer characteristic of the vehicle, which is determined based on lengths between the mass center CG and a front wheel axle and between the mass center CG and a rear wheel axle and forces acting on tires of the vehicle), and $\alpha$ = steering gear ratio.

The corrections of the wheel speeds are performed as follows.

The wheel speeds need to be corrected when the two dimensional set-up course line LC2 is converted into the one dimensional set-up course line LC1, because the inner and outer wheel speeds are different from each other when cornering, while they are the same when running straight. Therefore, a difference between wheel speeds is computed geometrically based on the cornering radius of the banked road and distances between the wheels and the mass center CG of the vehicle, and is used to correct the wheel speed. These corrected wheel speeds are inputted to the VDC/TCS/ABS control unit 4.

In the following equations, suffixes are used as follows: fl = front left, fr = front right, rl = rear left, and rr = rear right.

Tangential wheel speeds Vwfl', Vwfr', Vwrl', and Vwrr' are computed by multiplying the yaw rate by cornering radius of each wheel.

$$Vwfl' = \{(r - Df)^2 + L1^2\}^{1/2} \times \omega i$$

$$Vwfr' = \{(r + Df)^2 + L1^2\}^{1/2} \times \omega i$$

$$Vwrl' = \{(r - Dr)^2 + L2^2\}^{1/2} \times \omega i$$

$$Vwrr' = \{(r + Dr)^2 + L2^2\}^{1/2} \times \omega i$$

The wheel speed corrections $\Delta Vwfl$, $\Delta Vwfr$, $\Delta Vwrl$, and $\Delta Vwrr$ of the inner and outer wheels with respect to mass center speed are computed as follows.

$$\Delta Vwfl = Vwfl' - Vcar$$

$$\Delta Vwfr = Vwfr' - Vcar$$

$$\Delta Vwrl = Vwrl' - Vcar$$

$$\Delta Vwrr = Vwrr' - Vcar$$

The corrected wheel speeds Vwfl, Vwfr, Vwrr, and Vwrr are computed by adding the wheel speed corrections to wheel speed obtained in the virtual wheel model.

$$Vwfl = Vwfl + \Delta Vwfl$$

$$Vwfr = Vwfr + \Delta Vwfr$$

$$Vwrl = Vwrl + \Delta Vwrl$$

$$Vwrr = Vwrr + \Delta Vwrr,$$

where Df = front tread, Dr = rear tread, L1 = the length between the front axle and the mass center CG of the vehicle, L2 = the length between the rear axle and the mass center CG, $\omega i$ = yaw rate when the vehicle runs on the banked road, and Vcar = mass center speed (vehicle body speed).

When the vehicle runs on a banked road, yaw rate and lateral acceleration with respect to a steering angle are different from those caused when the vehicle runs on a flat surface road, causing VDC system to operate earlier. Suppression of the VDC operation so as to avoid this problem and ensuring the VDC operation to obtain the stability of the vehicle, therefore, are in a trade-off relation.

The VDC system controls a lateral slip amount of the vehicle obtained based on information from the yaw rate sensor 17 and the wheel speed sensors 13 to 16 to match with a target slip amount determined based on the steering operation amount caused by driver's steering operation and the brake operation amount detected from the brake pressure sensor 9. The system tends to start its operation earlier when the vehicle runs on the banked road such that the vehicle can corner with a small steering operation as well as it runs on the flat surface road, because the actual, lateral slip amount becomes larger than the target slip amount, resulting in a lateral slip difference between them exceeding a set-value.

In order to avoid the above problems, the actual system is conventionally installed on the actual vehicle and tested by actually running the vehicle on a slippery road, while the modeling system of the embodiment can simulate it using the virtual vehicle model, the road model, and the actual VDC system.

In order to obtain an optimum road model, three road models are tested: a first road model MAthat has three dimensional coordinates data on the road surface to supply a bank angle at every position of the vehicle, a second road model MB constructed by polyhedron combining many triangular surfaces to represent a road surface, and a third road model consisting of a course line where the test vehicle runs not so as to deviate from it.

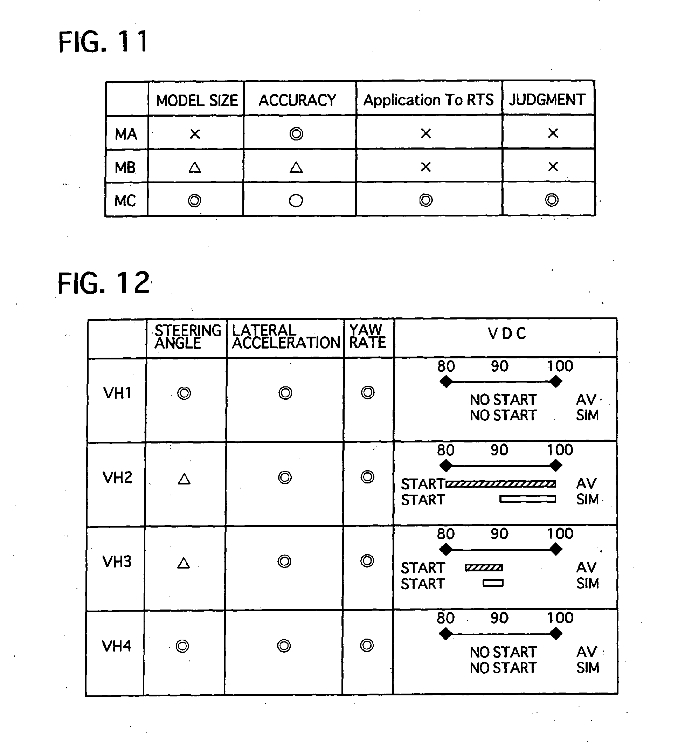

FIG. 11 shows an evaluation table among the three road models. The first road model MA can obtain the highest accurate results of them with measurement being possible at every position of the course and after the vehicle deviates from the course. The first road model MA, however, has very slow process speed due to a large sized data and have not functions to be operatable in the real time simulator 2. The second road model MB can obtain measured data when the vehicle deviates from the course, while its road model becomes discontinuous, and judgment between the surfaces becomes difficult. The third road model MC can not obtain measured data when the vehicle deviates from the course, while it can represent the road continuously and accurately due to information on high speed lane and shorten its computation.

FIG. 12 shows a comparison table between actual vehicle (AV) data and simulation (SM) data of first to fourth test vehicles VH1 to VH4, including VDC start/ no-operation of the vehicles VH1 to VH4 in speed range between 80 km/h and 100 km/h.

In the first and fourth test vehicles VH1 and VH4, their simulation and actual vehicle data almost corresponded to each other, and the VDC system did not operate in the simulation as well as the actual vehicle. In the second and third test vehicle VH2 and VH3, their lateral accelerations and yaw rates almost corresponded to those of the actual vehicle data. The VDC system operates in a certain speed range narrower than that of the actual vehicle data. The steering angle difference between the actual vehicle data and the simulation data was equal to or less than 15 degrees.

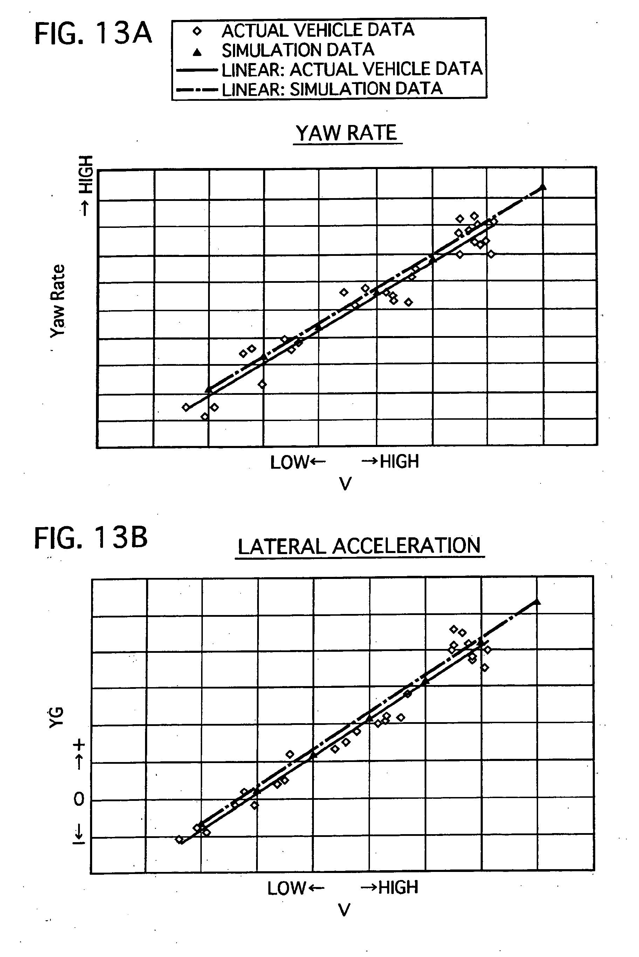

FIGS. 13A and 13B show comparison tables of yaw rate and lateral acceleration obtained by using an actual vehicle and the simulation described above with respect to vehicle speed when the vehicle runs on road with the bank of the highest inclination, respectively. These tables show that the simulated results mate well with the actual vehicle data.

The three dimensional road-vehicle modeling system of the embodiment has the following advantages.

The modeling system can convert the three dimensional road into the one dimensional road by using inclination angle of the road and the external forces acting on the test vehicle, which enables the simulation to duly represent the behavior of the vehicle running on the three dimensional road with decreasing processing load. In addition, the three dimensional road model is made up of the straight line of the one dimensional road, and thus the three dimensional road model becomes small memory capacity of minimum data on the road for computing, resulting in vastly decreasing computation time.

The modeling system uses a virtual vehicle model and an actual test system or test units to be evaluated, so that the system can evaluate compatibility between a vehicle dynamics control system and a test vehicle with high accuracy, including confirmation of trade-off relationship between earlier operation start of a VDC system of the vehicle running on the three dimensional road and operation start of the VDC system of the vehicle running on the two dimensional road.

The three dimensional road model is constructed allowing for correction of inclination of the road, steering angle, and/or wheel speeds: the computed state quantities of the vehicle in its lateral direction, such as a yaw rate and/or lateral acceleration, becomes smaller with bank angle; the computed steering angle increases with decreasing cornering radius; the computed wheel speed difference between an inner and outer wheel increases with decreasing cornering radius. These corrections enables the three dimensional simulation to be performed with high accuracy. Moreover, when the computed steering angle and wheel speeds are corrected based on cornering radius and characteristic of its vehicle dynamics, the simulation can improve its reproduction compared to one using geometrical corrections and the three dimensional road-vehicle model can be constructed based on the dynamics of the vehicle.

While there have been particularly shown and described with reference to preferred embodiments thereof, it will be understood that various modifications may be made therein, and it is intended to cover in the appended claims all such modifications as fall within the true spirit and scope of the invention.

For example, in the three dimensional road-wheel modeling system, the actual system or units to be tested may be other system or units, such as an anti-lock braking system, a regenerative braking system using a motor/ generator, driving force distributing system like an electronically controlled all-wheel drive train, in stead of the VDC system of the embodiment.

The first and second conversion parts211 and 212 may be provided in the personal computer 1 instead of the real time simulator 2.

**Claims**

1. A three dimensional road-vehicle modeling system comprising:

    an input device (1) to input three dimensional road data on a three dimensional road;
    a road data storing medium (1) to store the three dimensional road data inputted by said input device (1);
    a three dimensional course line setting device (1) to set a three dimensional course line of a vehicle (50) running on the three dimensional road;
    a first converter (2) to convert the three dimensional course line (LC3) on the three dimensional road obtained from said road data storing medium (1) into a two dimensional course line (LC2) on a two dimensional plane determined based on inclination of the three dimensional road; and

a second converter (2) to convert the two dimensional course line (LC2) into a straight course line (LC1) corresponding to a three dimensional road model on the two dimensional plane based on hypothetical external force acting on the vehicle (50).

2. A three dimensional road-vehicle modeling system as set forth in claim 1, wherein the straight course line (LC1) is converted so that the vehicle (50) runs on the straight course line with receiving the hypothetical external force obtained by adding centrifugal force to a slope-perpendicular component of gravity each acting on the vehicle (50) and with being steered.

3. A three dimensional road-vehicle modeling system as set forth in claim 1 or claim 2, further comprising:

an actual part(s) (5 to 16) to be tested;
a virtual vehicle model storing medium (1) to store a virtual vehicle model having characteristic parameters of vehicle parts including said actual part(s) (5 to 16), the characteristic parameters being fittable to a test vehicle with said actual part(s) (5 to 16); and
a real time simulator (2) to obtain simulation data from said actual part(s) (5 to 16) when said actual part(s) 5 to 16) are operated;

wherein said real time simulator (2) runs a simulation on real time using the three dimensional road model and the virtual vehicle model to obtain the simulation data, and evaluates compatibility between said actual part (s) (5 to 16) and the test vehicle.

4. A three dimensional road-vehicle modeling system as set forth in claim 3, wherein said real time simulator (2) produces a simulation input data by correcting state quantity of a lateral vehicle movement obtained by a computation of a dynamics equation using the three dimensional road model and the virtual vehicle model to be deceased with increasing bank angle of the three dimensional road.

5. A three dimensional road-vehicle modeling system as set forth in claim 3 or claim 4,
wherein said real time simulator (2) produces a simulation input data by correcting a steering angle obtained by a computation of a dynamics equation using the three dimensional road model and the virtual vehicle model to be larger with decreasing cornering radius of the vehicle (50).

6. A three dimensional road-vehicle modeling system as set forth in any one of claims 3 to 5, wherein said real time simulator (2) produces a simulation input data by correcting wheel speeds obtained by a computation of a dynamics equation using the three dimensional road model and the virtual vehicle model so that a speed difference between an inner and outer wheels increases with decreasing cornering radius of the vehicle (50).

7. A three dimensional road-vehicle modeling system as set forth in any one of claim 3 to 6, wherein said real time simulator (2) produces a simulation input data by correcting one of a steering angle and wheel speeds obtained by a computation of a dynamics equation using the three dimensional road model and the virtual vehicle model based on a cornering radius and dynamic characteristic of the vehicle (50).

8. A three dimensional road-vehicle modeling system as set forth in any one of claim 3 to 7, wherein said actual part (s) (5 to 16) belong to a vehicle dynamics control system.

## FIG. 1A

- 201 — EVALUATIONprog.
- 202 — ACSYS
- 203 — MATLAB/simulink
- 204 — Windows

200

## FIG. 1B

301 — ACSYS Control
302 — RTS ENVIRONMENT
300

# FIG. 2

FIG. 3

EP 1 544 760 A2

FIG. 4

EP 1 544 760 A2

14

## FIG. 5

## FIG. 6

FIG. 7A

FIG. 7B

FIG. 7C

**FIG. 8**

$$Fy = F \times \cos\theta$$
$$F = m \times V^2/r$$
$$Fz = F \times \sin\theta$$

**FIG. 9A**

$$Ky = m \times g \times \sin\theta$$
$$m \times g$$
$$Kz = m \times g \times \cos\theta$$

**FIG. 9B**

$$Kx = m \times g \times \sin\tau$$
$$m \times g$$
$$Kz2 = m \times g \times \cos\tau$$

## FIG. 10

```
          ( START )
              │
┌─────────────────────────────────┐
│   READ SPECIFICATIONS OF VEHICLE │──S1
└─────────────────────────────────┘
              │
┌─────────────────────────────────┐
│      SET RUNNING CONDITIONS      │──S2
└─────────────────────────────────┘
              │                    ┌S3
        ╱─────────────────────────╲  NO
       ⟨       3D SIMULATION ?      ⟩────────────────┐
        ╲─────────────────────────╱                 │
              │ YES                                  │
┌─────────────────────────────────┐                 │
│        READ 3D COURSE LINE       │──S4             │
└─────────────────────────────────┘                 │
              │                          ┌S13        │
┌─────────────────────────────────┐   ┌─────────────▼──┐
│     CONVERSION TO 2D COURSE LINE │──S5 │ COMPUTATION    │
└─────────────────────────────────┘   │ BY DYNAMICS    │
              │                        │ EQUATION FROM  │
┌─────────────────────────────────┐   │ 2D COURSE DATA │
│       COMPUTE SLOPE ANGLES       │──S6 └────────────────┘
└─────────────────────────────────┘                 │
              │                                      │
┌─────────────────────────────────┐                 │
│          START VEHICLE           │──S7             │
└─────────────────────────────────┘                 │
              │                                      │
┌─────────────────────────────────┐                 │
│      COMPUTE MILEAGE OF VEHICLE  │──S8             │
└─────────────────────────────────┘                 │
              │                                      │
┌─────────────────────────────────┐                 │
│      COMPUTE CENTRIFUGAL FORCE   │──S9             │
└─────────────────────────────────┘                 │
              │                                      │
┌─────────────────────────────────┐                 │
│  COMPUTE COMPONENT OF SLOPE FORCE│──S10            │
└─────────────────────────────────┘                 │
              │                                      │
┌─────────────────────────────────┐                 │
│      CONVERSION TO 1D COURSE LINE│──S11            │
└─────────────────────────────────┘                 │
              │                                      │
┌─────────────────────────────────┐                 │
│  CORRECTION OF YAW RATE, LATERAL │──S12            │
│  ACCELERATION, STEERING ANGLE,   │                 │
│         WHEEL SPEEDS             │                 │
└─────────────────────────────────┘                 │
              │◄────────────────────────────────────┘
┌─────────────────────────────────┐
│             OUTPUT               │──S14
└─────────────────────────────────┘
              │
          ( RETURN )
```

# FIG. 11

| | MODEL SIZE | ACCURACY | Application To RTS | JUDGMENT |
|---|---|---|---|---|
| MA | × | ◎ | × | × |
| MB | △ | △ | × | × |
| MC | ◎ | ○ | ◎ | ◎ |

# FIG. 12

| | STEERING ANGLE | LATERAL ACCELERATION | YAW RATE | VDC |
|---|---|---|---|---|
| VH1 | ◎ | ◎ | ◎ | 80 90 100 — NO START AV / NO START SIM |
| VH2 | △ | ◎ | ◎ | 80 90 100 — START▨▨▨▨ AV / START ▭ SIM |
| VH3 | △ | ◎ | ◎ | 80 90 100 — START ▨▨ AV / START ▭ SIM |
| VH4 | ◎ | ◎ | ◎ | 80 90 100 — NO START AV / NO START SIM |

## FIG. 13A

| | |
|---|---|
| ◇ | ACTUAL VEHICLE DATA |
| ▲ | SIMULATION DATA |
| —— | LINEAR: ACTUAL VEHICLE DATA |
| —·— | LINEAR: SIMULATION DATA |

### YAW RATE

## FIG. 13B

### LATERAL ACCELERATION